Europäisches Patentamt

European Patent Office

Office européen des brevets

(11) Numéro de publication: **0 439 982 A2**

## DEMANDE DE BREVET EUROPEEN

(21) Numéro de dépôt: 90440045.4

(22) Date de dépôt: 22.05.90

(51) Int. Cl.⁵: **H05K 11/00, H04N 5/265**

(30) Priorité: 18.01.90 FR 9000712

(43) Date de publication de la demande:
07.08.91 Bulletin 91/32

(84) Etats contractants désignés:
AT BE CH DE DK ES GB GR IT LI LU NL SE

(71) Demandeur: SANDVALE S.A.
33, rue des Jardins

F-68000 Colmar(FR)

(72) Inventeur: Valetti, Roger
"Les Graviers Rouges", Les Guillemottes
F-38200 Vienne(FR)

(74) Mandataire: Nuss, Pierre et al
10, rue Jacques Kablé
F-67000 Strasbourg(FR)

(54) **Dispositif automatique d'interconnexion de plusieurs appareils électroniques, audio et/ou vidéo et/ou informatiques.**

(57) La présente invention concerne un dispositif automatique d'interconnexion de plusieurs appareils électroniques, audio et/ou vidéo et/ou informatiques.

Dispositif caractérisé en ce qu'il est essentiellement constitué par un boîtier électronique (1) comportant au moins quatre prises péritélévision (2, 3, 4, 5) et, le cas échéant, au moins une prise DIN (6) et permettant, par l'intermédiaire de cordons de raccordement correspondants, de réaliser une interconnexion à configuration variable entre au moins quatre appareils de type audio et/ou vidéo et/ou informatique (8 à 12) au moyen, notamment, de circuits de commutation (13, 13', 14) commandés indépendamment les uns des autres, tout en conservant la même structure de connexions physiques du boîtier électronique avec les appareils connectés (8 à 12) et sans modification du mode d'emploi habituel de ces derniers.

Fig-1

EP 0 439 982 A2

# DISPOSITIF AUTOMATIQUE D'INTERCONNEXION DE PLUSIEURS APPAREILS ÉLECTRONIQUES, AUDIO ET/OU VIDÉO ET/OU INFORMATIQUES

La présente invention concerne le domaine de la connexion fonctionnelle de plusieurs appareils électroniques, notamment audio et/ou vidéo et/ou informatiques, permettant de réaliser des opérations de visualisation, de reproduction, de traitement et d'enregistrement des signaux entre les différents appareils connectés, et a pour objet un dispositif automatique d'interconnexion de plusieurs appareils électroniques audio et/ou vidéo et/ou informatiques.

Actuellement, de nombreux ménages possèdent, en plus du téléviseur, un magnétoscope et un décodeur pour la réception d'une chaîne codée ainsi que, de plus en plus fréquemment, également un syntoniseur satellite, un appareil compact disques vidéo, un caméscope, un micro-ordinateur, des consoles de jeux vidéo, un appareil à sorties Rouge-Vert-Bleu, etc..., et même, dans certains cas, un deuxième téléviseur et/ou magnétoscope.

Les appareils sont généralement reliés entre eux de manière directe, au moyen de cordons de raccordement présentant à leurs extrémités des connecteurs destinés à être branchés directement sur les différents appareils à interconnecter.

Or, dans la plupart des cas, lesdits appareils ne sont pourvus que d'une seule prise de raccordement ce qui oblige l'utilisateur, lors d'opérations de reproduction et/ou d'enregistrement par exemple, à opérer de fréquentes déconnexions et reconnexions selon la nature, l'emplacement et les connexions antérieures de l'appareil source et de l'appareil récepteur, ainsi qu'à chaque fois que l'utilisateur a l'intention de vérifier le déroulement de l'enregistrement et/ou de la reproduction. Ces fréquentes interventions manuelles, liées, par ailleurs, a des difficultés d'accès aux connecteurs, découlant de leur emplacement sur les appareils à connecter, sont, à long terme, frustrants pour l'utilisateur qui n'a pas la possibilité d'exploiter efficacement et sans manipulation fastidieuse l'ensemble d'appareils partiellement interconnectés.

Il existe, certes, des adaptateurs, notamment audio-vidéo, présentant des fonctionnements manuels, semi-automatiques ou même automatiques et permettant de pallier en partie les inconvénients précités.

Néanmoins, les adaptateurs existants sont conçus en général pour s'adapter spécifiquement à un certain type d'appareils, notamment à un certain type de magnétoscopes et sont limités à l'interconnexion de trois appareils au maximum. En outre, leur utilisation entraîne fréquemment une modification du mode d'emploi habituel des différents appareils connectés ainsi qu'une interdépendance desdits appareils, ne permettant pas à l'utilisateur de les faire fonctionner à volonté simultanément ou séparément, selon la programmation de chacun des appareils par l'utilisateur.

La présente invention a pour but de pallier l'ensemble des inconvénients précités.

Elle a, en effet, pour objet un dispositif automatique d'interconnexion de plusieurs appareils électroniques, notamment audio et/ou vidéo et/ou informatiques, tels que, par exemple, téléviseurs, magnétoscopes, décodeurs, syntoniseurs satellite, lecteur de compact disques vidéo, consoles de jeux vidéo, caméscopes, appareils à sorties Rouge-Vert-Bleu, etc..., caractérisé en ce qu'il est essentiellement constitué par un boîtier électronique comportant au moins quatre prises péritélévision et, le cas échéant, au moins une prise DIN et permettant, par l'intermédiaire de cordons de raccordement correspondants, de réaliser une interconnexion à configuration variable entre au moins quatre appareils de type audio et/ou vidéo et/ou informatique au moyen, notamment, de circuits de commutation commandés indépendamment les uns des autres, tout en conservant la même structure de connexions physiques du boîtier électronique avec les appareils connectés et sans modification du mode d'emploi habituel de ces derniers.

L'invention sera mieux comprise grâce à la description ci-après, qui se rapporte à un mode de réalisation préféré, donné à titre d'exemple non limitatif, et expliqué avec référence aux dessins schématiques annexés, dans lesquels :

la figure 1 est un schéma par blocs d'un dispositif conforme à l'invention comportant quatre prises péritélévision et une prise DIN ;

la figure 2 est un schéma par blocs du dispositif de sélection de signaux faisant partie du dispositif représenté à la figure 1 ;

la figure 3 est un schéma par blocs du dispositif d'identification faisant également partie du dispositif représenté à la figure 1 ;

la figure 4 est un schéma par blocs du dispositif de détection de signaux faisant partie du dispositif conforme à l'invention et représenté à la figure 1, et,

les figures 5 à 9 sont des vues schématiques de différents ensembles d'appareils audio et/ou vidéo et/ou informatiques interconnectés au moyen du dispositif conforme à l' invention.

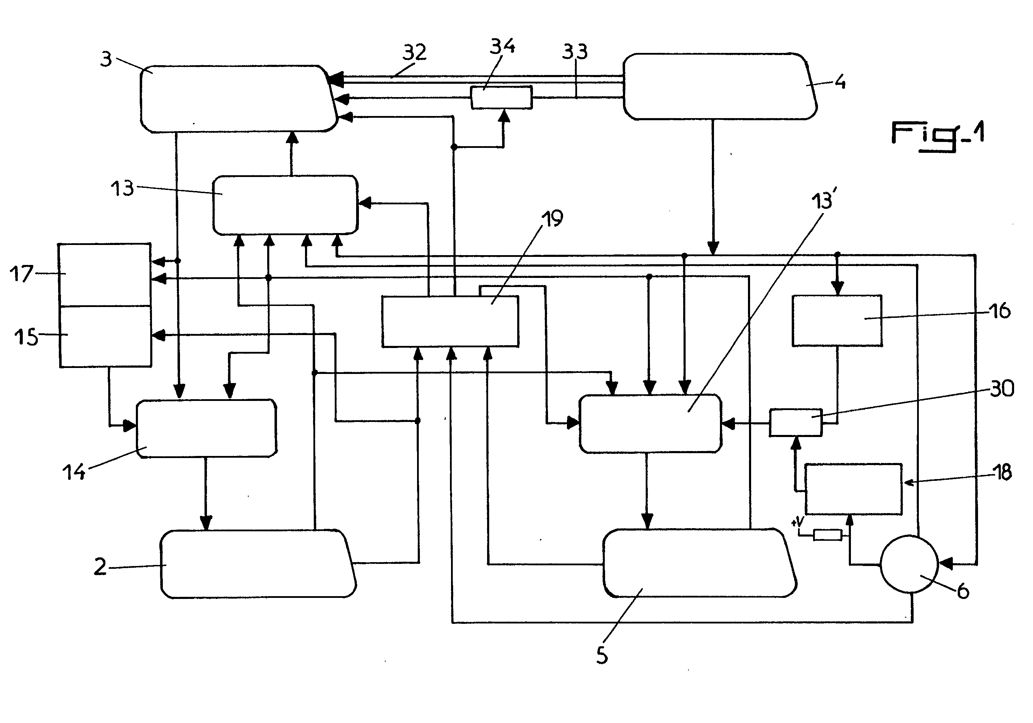

Conformément à l'invention, et comme le montrent les figures 1 et 5 à 9 des dessins annexés, le dispositif automatique d'interconnexion de plusieurs appareils électroniques, notamment audio et/ou vidéo et/ou informatique, est essentiellement constitué par un boîtier électronique 1 comportant au moins quatre prises péritélévision 2, 3, 4, 5 et, le cas échéant, au moins une prise DIN 6 et permettant, par l'intermédiaire de cordons de raccordement 7 correspondants, de réaliser une interconnexion à configuration variable entre au moins quatre appareils de type audio et/ou vidéo et/ou informatique 8 à 12 au moyen, notamment, de circuits de commutation 13, 13', 14 commandés indépendamment les uns des autres, tout en conservant la même structure de connexions physiques du boîtier électronique 1 avec les appareils connectés 8 à 12 et sans modification du mode d'emploi habituel de ces derniers.

Les différents circuits de commutation 13, 13', 14 sont disposés à l'entrée des prises péritélévision 2, 3 et 5, autorisant le branchement d'appareils 8 à 10 de visualisation, de reproduction, d'enregistrement ou de traitement des signaux audio-vidéo et reliés aux sorties de toutes ou de certaines des autres prises péritélévision 2 à 5 et DIN 6 du dispositif conforme à l'invention, et déterminent, par conséquent, par leur positionnement la provenance des signaux audio-vidéo envoyés sur les appareils 8 à 10 branchés sur les prises péritélévision 2, 3 et 5 correspondantes concernées.

La configuration des liaisons entre les différentes prises péritélévision 2 à 5 et la nature des signaux audio-vidéo transmis ne sont fonction que des programmations et des spécificités des différents appareils 8 à 10 branchés sur lesdites prises péritélévision 2 à 5.

Selon une première caractéristique de l'invention, et comme le montre également la figure 1 des dessins annexés, le dispositif automatique d'interconnexion comporte également, d'une part, des dispositifs 15 à 17, respectivement, de sélection de la provenance, de détection de la présence et d'identification de signaux audio-vidéo issus d'un ou de plusieurs des différents appareils 8 à 12 connectés, d'autre part, au moins un circuit de reconnaissance 18 du ou des systèmes du ou des magnétoscopes 9, 9' connectés au niveau de la ou des différentes prises DIN 6, et, enfin, au moins un dispositif de commande 19 de certains circuits de commutation 13, 13' selon les ordres hiérarchisés provenant de certains appareils connectés 9 à 10.

La description qui va suivre, ainsi que les figures des dessins annexés, se rapportent plus particulièrement à une réalisation préférée de l'invention sous la forme d'un dispositif automatique d'interconnexion comportant quatre prises péritélévision 2 à 5 et une prise DIN 6, étant entendu que ledit dispositif conforme à l'invention décrit ci-après, peut être aisément étendu à un dispositif automatique d'interconnexion comportant cinq, six ou plus de prises péritélévision 2, 3, 4, 5 et/ou deux, trois ou plus de prises DIN 6. Il suffirait, en effet, d'assurer la reproduction d'un ou de plusieurs ensembles prise péritélévision 2, 3, 4 ou 5 et/ou prise DIN 6 - dispositifs 15, 16 ou 17 et/ou circuits 13, 13', 14 ou 18 d'interfaçage correspondants ainsi que leur connexion aux différents circuits et/ou dispositifs et/ou prises correspondants.

Le dispositif de commande 19 est avantageusement sous la forme d'un circuit logique, constitué par une structure de composants logiques, dont les entrées, hiérarchisées, sont reliées aux pattes ou aux broches de sortie de commande des prises péritélévision 2 et 5 et DIN 6 permettant le branchement d'appareils 8 à 10 de visualisation, de reproduction, d'enregistrement ou de traitement des signaux audio-vidéo programmables par l'utilisateur.

Les tensions de sortie dudit circuit 19, appliquées en tant que signaux de commande aux circuits de commutation 13, 13' disposés à l'entrée des prises péritélévision 2 et 5 autorisant le branchement d'appareils 8, 8', 9, 9' de visualisation, de reproduction ou d'enregistrement, positionnent lesdits circuits de commutation 13, 13' et contrôlent, par conséquent, la circulation des signaux audio-vidéo entre les différents appareils 8 à 12 connectés.

Par contre, le circuit de commutation 14 déterminant la provenance des signaux audio-vidéo alimentant l'appareil de traitement 10 de signaux audio-vidéo est positionné grâce au dispositif de sélection 15 de la provenance des signaux audio-vidéo destinés à l'appareil de traitement 10.

Le circuit de reconnaissance 18 du système du magnétoscope 9, 9' branché au niveau de la prise DIN 6 se présente, par exemple, sous la forme d'un transistor travaillant en commutation dont l'entrée est reliée, d'une part, à un potentiel fixe + V par l'intermédiaire d'une impédance et, d'autre part, à une des broches de la prise DIN 6. Lors du branchement d'une fiche DIN reliée à un magnétoscope 9, 9', ladite broche de la prise DIN 6 sera mise à la masse et le transistor délivrera par conséquent une tension caractéristique du système de magnétoscope 9, 9' branché.

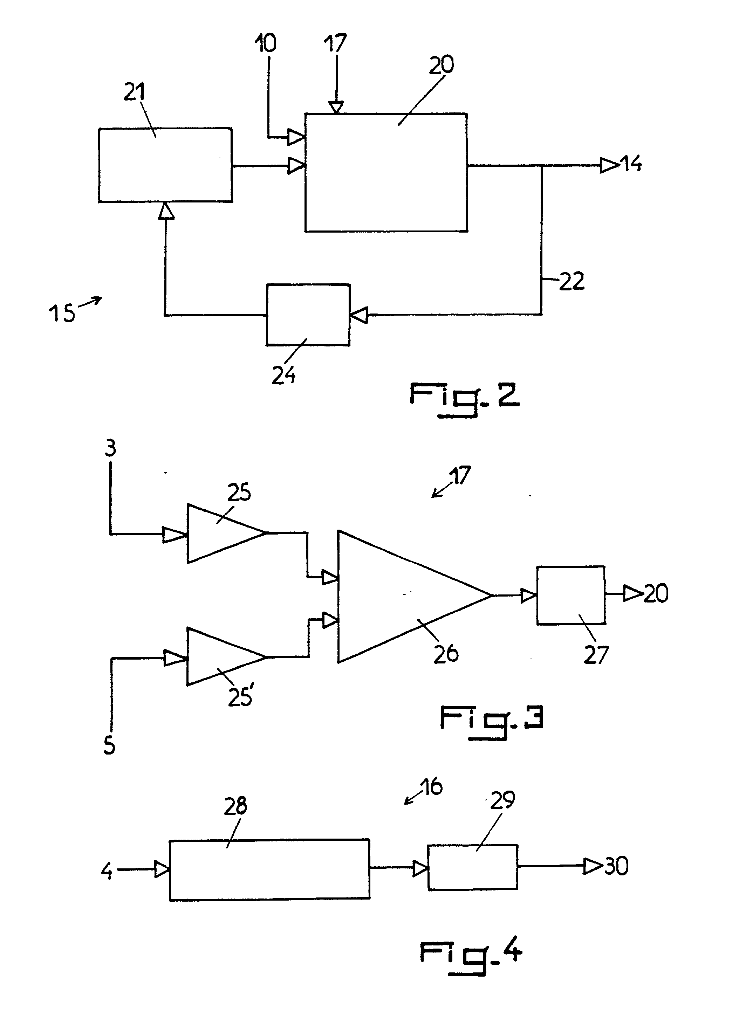

Conformément à une caractéristique de l'invention, représentée à la figure 2 des dessins annexés, ledit dispositif de sélection 15 de la provenance de signaux audio-vidéo est constitué, d'une part, par un circuit de commutation 14 commandé, déterminant par son positionnement la provenance des signaux audio-vidéo délivrés à un appareil de traitement 10 des signaux audio-vidéo branché sur la prise péritélévision 2 correspondante, d'autre part, par un circuit logique de sélection 20 excité par un générateur d'impulsions 21 et contrôlant le positionnement du circuit de commutation 14, et, enfin, par une boucle 22 de verrouillage dudit dispositif de sélection 15 lors de la présence, sur l'une des entrées du circuit de commutation 14, de signaux audio-vidéo compatibles avec ledit appareil de traitement 10 connecté.

Ce dernier peut se présenter, par exemple, de manière non limitative, sous la forme d'un décodeur de signaux audio-vidéo codés, tel que, notamment, un décodeur de chaîne cryptée.

Aussi longtemps qu'aucun signal audio-vidéo provenant des autres appareils connectés 8, 8', 9 et 9' munis d'un moyen de réception 23 desdits signaux et compatible avec l'appareil de traitement 10 de signaux ne se présente sur les entrées du circuit de commutation 14 précédant ledit appareil 10, ledit circuit 14 est commuté en permanence par le générateur d'impulsions 21 : il en résulte un balayage scrutatif des différentes entrées du circuit de commutation 14. Mais, dès qu'un signal audio-vidéo compatible apparaît sur l'une des entrées du circuit de commutation 14, celui-ci est reconnu par l'appareil de traitement 10 de signaux, aussitôt que ledit circuit 14 est commuté sur l'entrée correspondante. L'appareil de traitement 10 des signaux envoie alors une commande de blocage vers le circuit logique de sélection 20 qui bloque le circuit de commutation 14 sur l'entrée présentant ledit signal audio-vidéo compatible. Simultanément, le générateur d'impulsions 21 est verrouillé par la boucle de verrouillage 22 comportant, notamment, un circuit latch 24.

Néanmoins, dans le cas où des signaux audio-vidéo compatibles apparaissent simultanément sur plusieurs entrées dudit circuit de commutation 14, il est nécessaire d'établir un ordre de priorité, les appareils de traitement 10 de signaux ne pouvant, en général, pas traiter simultanément des signaux audio-vidéo issus de plusieurs appareils 8, 8', 9 ou 9'.

Ceci est notamment le cas pour les décodeurs de chaînes cryptées, pour lesquels il faut, pour pouvoir visionner, en cours d'enregistrement au moyen d'un magnétoscope 9 ou 9', un programme crypté au moyen d'un téléviseur 8 ou 8', commuter ce dernier sur le programme réservé audit magnétoscope 9 ou 9' ou en mode de visionnage simultané.

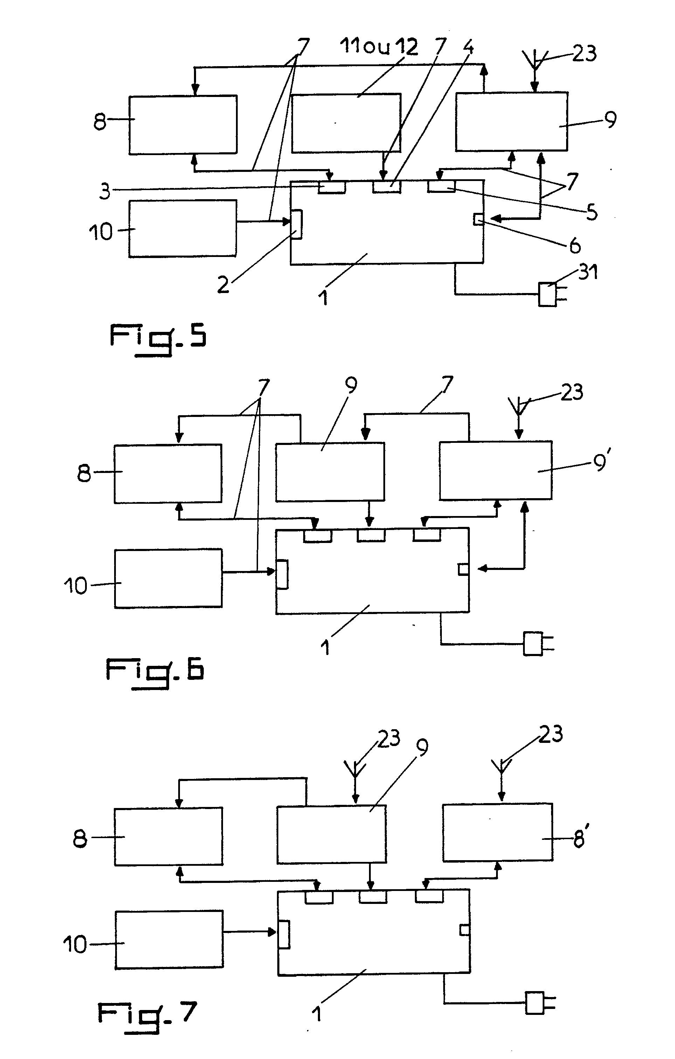

Ce problème est résolu par le dispositif automatique d'interconnexion conforme à l'invention, grâce au dispositif d'identification 17 des signaux audio-vidéo provenant de plusieurs appareils 8, 8', 9 ou 9' connectés, représenté à la figure 3 des dessins annexés et constitué par au moins deux circuits 25, 25' extracteurs de signaux de synchronisation, branchés sur les entrées d'un circuit comparateur 26 dont le signal de sortie est appliqué, par l'intermédiaire d'un circuit de filtrage anti-parasite 27, au circuit logique de sélection 20.

Les deux circuits 25, 25' se présentent avantageusement sous la forme de deux amplificateurs à gain élevé qui réagissent aux impulsions de synchronisation incluses dans les signaux vidéo et les amplifient.

Par conséquent, ledit dispositif d'identification 17 indique au dispositif de sélection 15 sur quelles entrées du circuit de commutation 14 des signaux audio-vidéo compatibles avec l'appareil de traitement 10 sont présents, par comparaison des signaux de synchronisation des différents signaux audio-vidéo présents aux différentes entrées du circuit de commutation 14 entre eux. Selon un ordre de priorité prédéterminé, le circuit logique de sélection 20 déterminera l'appareil 8, 8', 9 ou 9' dont les signaux audio-vidéo compatibles seront transmis à l'appareil de traitement 10 de signaux audio-vidéo, les émissions de signaux audio-vidéo compatibles en provenance des autres appareils 8, 8', 9 ou 9' étant stoppées par une commande appropriée issue dudit appareil de traitement 10 et transmise par le dispositif de commande 19. Néanmoins, tous les appareils 8, 8', 9, 9' de visualisation, de reproduction et d'enregistrement connectés peuvent recevoir les signaux audio-vidéo traités issus de l'appareil de traitement 10 simultanément, sans qu'un positionnement des circuits de commutation 13, 13' des appareils concernés 8, 8', 9, 9' sur les entrées reliées à l'appareil prioritaire 9 ou 9' ne soit nécessaire.

De même, dès que l'appareil prioritaire n'envoie plus de signaux audio-vidéo compatibles, le circuit de commutation 14 est positionné par le circuit logique de sélection 20 de telle manière que les signaux audio-vidéo compatibles issus de l'appareil de priorité inférieure soient alors transmis à l'appareil de traitement 10.

Dans le cas d'un décodeur 10 de chaîne cryptée, il est alors possible de visionner au moyen d'un téléviseur 8, 8' ladite chaîne sur le programme réservé à cette chaîne indépendamment du fait qu'un magnétoscope 9, 9' enregistre ou non cette dernière.

Comme le montrent les figures 1 et 4 des dessins annexés, le dispositif de détection 16 de la présence de signaux vidéo, au niveau d'une prise péritélévision 4 destinée spécifiquement à une transmission unilatérale de signaux audio-vidéo vers l'intérieur du boîtier 1, se présente, préférentiellement, sous la forme d'un amplificateur 28 de signaux audio-vidéo auquel est relié un circuit de filtrage 29, son signal de sortie étant appliqué, ensemble avec le signal de sortie du dispositif de reconnaissance 18 du système du magnétoscope 9, 9' connecté sur la prise DIN 6 et par l'intermédiaire d'un port 30, à une entrée de commande du circuit de commutation 13' déterminant la provenance des signaux audio-vidéo alimentant ledit magnétoscope 9 ou 9'.

Il est ainsi possible, d'une part, d'adapter la transmission des signaux audio-vidéo, par le dispositif automatique d'interconnexion conforme à l'invention, aux divers types de magnétoscopes 9, 9' et, d'autre part, de signaler au magnétoscope 9 ou 9' branché à la sortie du circuit de commutation 13', la présence d'une source de signaux audio-vidéo au niveau de la prise péritélévision 4 destinée spécifiquement à une transmission de signaux audio-vidéo vers l'intérieur du boîtier 1.

Conformément à une caractéristique supplémentaire, également représentée à la figure 1, au moins deux prises péritélévision 3, 4 du dispositif automatique d'interconnexion, sont reliées de manière directe au moyen d'un bus Rouge-Vert-Bleu 32, la transmission entre les prises 3, 4 concernées étant séquencée par une ligne de commande 33 contrôlée par 1e dispositif de commande 19 au moyen d'un port 34.

Les figures 5 à 9 des dessins annexés représentent, à titre d'exemples, différents ensembles cohérents d'appareils audio et/ou vidéo et/ou informatiques réalisés au moyen du dispositif automatique d'interconnexion conforme à l'invention et muni de quatre prises péritélévision 2 à 5 et d'une prise DIN 6.

Ainsi, la figure 5 des dessins annexés montre de manière schématique un ensemble audio et/ou vidéo et/ou informatique interconnecté composé d'un décodeur 10 d'une chaîne de télévision codée, d'un téléviseur 8, d'un syntoniseur satellite 11 ou d'une console de jeux vidéo 12 et d'un magnétoscope 9, le dispositif autcmatique d'interconnexion étant alimenté par une prise de courant 31.

Cet ensemble audio-visuel permet ainsi, simultanément et indépendamment, d'enregistrer au moyen du magnétoscope 9, soit un programme de télévision en clair reçu au moyen du syntoniseur satellite 11 ou de 1'antenne traditionnelle 23, soit un programme de chaîne codée reçu au moyen de l'antenne traditionnelle 23 et traité par le décodeur 10, et de visionner au moyen du téléviseur 8 1e programme en train d'être enregistré ou un autre, selon la programmation du téléviseur 8 et du magnétoscope 9 par l'utilisateur. Il est bien évidemment toujours possible de visionner, au moyen du téléviseur 8, une cassette vidéo lue par le magnétoscope 9. Lorsque le syntoniseur satellite 11 est remplacé par une console de jeux vidéo 12, le téléviseur 8 est utilisé en tant qu'écran de visualisation.

L'ensemble audio-visuel interconnecté représenté à la figure 6 des dessins annexés comprend un décodeur 10 de chaîne de télévision codée, un téléviseur 8, un premier magnétoscope 9 utilisé uniquement pour la lecture ainsi qu'un deuxième magnétoscope 9'.

La figure 7 des dessins annexés montre un autre exemple d'un ensemble d'appareils audio-visuels comportant quatre appareils 8, 8', 9 et 10 interconnectés, à savoir, un décodeur 10 de chaîne de télévision codée, un premier téléviseur 8, un magnétoscope 9 utilisé en lecture uniquement et un deuxième téléviseur 8'.

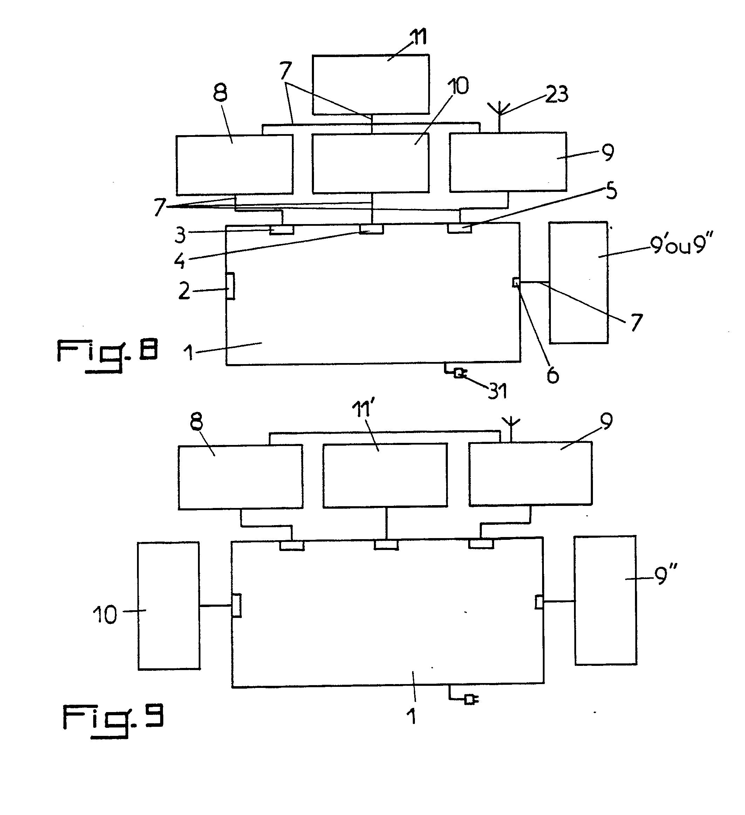

Il est également possible de capter les signaux audio-vidéo codés au moyen du syntoniseur satellite 11, comme le montre la figure 8 des dessins annexés. Dans ce cas, le décodeur 10 est branché sur la prise péritélévision 4 destinée à la transmission unilatérale de signaux audio-vidéo vers les prises 3, 5 et 6. Sur ces denières peuvent être branchés, respectivement, un téléviseur 8, un magnétoscope 9 et, en ce qui concerne la prise DIN 6, un deuxième magnétoscope 9' ou un caméscope 9".

Enfin, la figure 9 des dessins annexés représente à titre d'exemple un ensemble de cinq appareils audio-visuels interconnectés comportant un décodeur 10, un téléviseur 8, un lecteur vidéodisque 11', un magnétoscope 9 et un camescope 9".

Bien entendu, l'invention n'est pas limitée au mode de réalisation décrit et représenté aux dessins annexés. Des modifications restent possibles, notamment du point de vue de la constitution des divers éléments, ou par substitution d'équivalents techniques, sans sortir pour autant du domaine de protection de l'invention.

**Revendications**

1. Dispositif automatique d'interconnexion de plusieurs appareils électroniques, notamment audio et/ou vidéo et/ou informatiques, tels que, par exemple, téléviseurs, magnétoscopes, décodeurs, syntoniseurs satellite, lecteur de compact disques vidéo, consoles de jeux vidéo, camescopes, appareils à sorties Rouge-Vert-Bleu, etc..., caractérisé en ce qu il est essentiellement constitué par un boîtier électronique (1) comportant au moins quatre prises péritélévision (2, 3, 4, 5) et, le cas échéant, au moins une prise DIN (6) et permettant, par l'intermédiaire de cordons de raccordement (7) correspondants, de réaliser une interconnexion à configuration variable entre au moins quatre appareils de type audio et/ou vidéo et/ou informatique (8 à 12) au moyen, notamment, de circuits de commutation (13, 13', 14) commandés indépendamment les uns des autres, tout en conservant la même structure de connexions physiques du boîtier électronique (1) avec les appareils connectés (8 à 12) et sans modification du mode d'emploi habituel de ces derniers.

2. Dispositif, selon la revendication 1, caractérisé en ce qu'il comporte également, d'une part, des dispositifs (15 à 17), respectivement, de sélection de la provenance, de détection de la présence et d'identification de signaux audio-vidéo issus d'un ou de plusieurs des différents appareils (8 à 12) connectés, d'autre part, au moins un circuit de reconnaissance (18) du ou des systèmes du ou des magnétoscopes (9, 9') connectés au niveau de la ou des différentes prises DIN (6), et, enfin, au moins un dispositif de commande (19) de certains circuits de commutation (13, 13') selon les ordres hiérarchisés provenant de certains appareils connectés (9 à 10).

3. Dispositif, selon la revendication 2, caractérisé en ce que le dispositif de sélection (15) de la provenance des signaux audio-vidéo est constitué, d'une part, par un circuit de commutation (14) commandé, déterminant par son positionnement la provenance des signaux audio-vidéo délivré à un appareil de traitement (10) des signaux audio-vidéo branché sur la prise péritélévision (2) correspondante, d'autre part, par un circuit logique de sélection (20) excité par un générateur d'impulsions (21) et contrôlant le positionnement du circuit de commutation (14), et, enfin, par une boucle (22) de verrouillage dudit dispositif de sélection (15) lors de la présence, sur l'une des entrées du circuit de commutation (14), de signaux audio-vidéo compatibles avec ledit appareil de traitement (10) connecté.

4. Dispositif, selon l'une quelconque des revendications 2 et 3, caractérisé en ce que le dispositif d'identification (17) des signaux audio-vidéo provenant de plusieurs appareils (8, 8', 9, 9') connectés est avantageusement constitué par au moins deux circuits (25, 25') extracteurs de signaux de synchronisation, branchés sur les entrées d'un circuit comparateur (26) dont le signal de sortie est appliqué, par l'intermédiaire d'un circuit de filtrage anti-parasite (27), au circuit logique de sélection (20).

5. Dispositif, selon l'une quelconque des revendications 2 à 4, caractérisé en ce que le dispositif de détection (16) de la présence de signaux vidéo, au niveau d'une prise péritélévision (4) destinée spécifiquement à une transmission unilatérale de signaux audio-vidéo vers l'intérieur du boîtier (1), se présente, préférentiellement, sous la forme d'un amplificateur (28) de signaux vidéo auquel est relié un circuit de filtrage (29), son signal de sortie étant appliqué, ensemble avec le signal de sortie du dispositif de reconnaissance (18) du système du magnétoscope (9, 9') connecté sur la prise DIN (6) et par l'intermédiaire d'un port (30), à une entrée de commande du circuit de commutation (13') déterminant la provenance des signaux audio-vidéo alimentant ledit magnétoscope (9 ou 9').

6. Dispositif, selon l'une quelconque des revendications 1 à 5, caractérisé en ce qu'au moins deux prises péritélévision (3, 4) sont reliées de manière directe au moyen d'un bus Rouge-Vert-Bleu (32), la transmission entre les prises (3, 4) concernées étant séquencée par une ligne de commande (33) contrôlée par le dispositif de commande (19) au moyen d'un port (34).

7. Dispositif, selon l'une quelconque des revendications 1 à 6, caractérisé en ce qu'il comporte avantageusement quatre prises péritélévision (2 à 5) et une prise DIN (6), sur lesquelles peuvent être branchés, respectivement, par exemple, un décodeur (10) de chaîne de télévision codée, un téléviseur (8), un syntoniseur satellite (11) et un magnétoscope (9), ce dernier étant connecté sur une prise péritélévision (5) et sur la prise DIN (6).

Fig_1

EP 0 439 982 A2

Fig. 2

Fig. 3

Fig. 4

7    11ou12    7    4    23

8    9    3    7    5    6    31    10    2    1

**Fig.5**

7    9    7    23

8    9'    10    1

**Fig.6**

23    9    23

8    9    8'    10    1

**Fig.7**

Fig. 8

Fig. 9